# EUROPÄISCHE PATENTSCHRIFT

(11) **EP 2 688 719 B1**
(45) Veröffentlichungstag und Bekanntmachung des Hinweises auf die Patenterteilung: **21.12.2016**
(21) Anmeldenummer: 12710866.0
(22) Anmeldetag: 28.02.2012
(51) Int. Cl.: B25J 15/00

(54) **VORRICHTUNG ZUM HANDHABEN VON GEGENSTÄNDEN**
DEVICE FOR HANDLING OBJECTS
DISPOSITIF POUR MANIPULER DES OBJETS

(30) Priorität: 22.03.2011 DE 102011014674
(43) Veröffentlichungstag der Anmeldung: 29.01.2014
(73) Patentinhaber: Global Safety Textiles GmbH, 79689 Maulburg (DE)
(72) Erfinder: RIETHMÜLLER, Christoph, 71229 Leonberg (DE); RUSCHULTE, Jörg, 79736 Rickenbach (DE)
(74) Vertreter: Fischer, Matthias
(86) Internationale Anmeldenummer: PCT/EP2012/000863
(87) Internationale Veröffentlichungsnummer: WO 2012/126567

(56) Entgegenhaltungen:
- DE-T5-112007 001 758
- JP-A- 2005 286 114
- JP-A- 2007 157 822
- US-A- 4 778 326
- US-A1- 2008 279 659

## Beschreibung

Die vorliegende Erfindung betrifft eine Vorrichtung zum Handhaben von Gegenständen gemäß dem Oberbegriff des Anspruchs 1, sowie ein Verfahren zum Handhaben von Gegenständen mit einer solchen Vorrichtung.
Eine solche Vorrichtung und ein solches Verfahren sind aus der JP-A-2007157822 bekannt.

Es sind mechanische und pneumatische Greifersysteme bekannt, welche in vorwiegend automatisiert gesteuerten Greifersystemen zur Manipulation von Gegenständen eingesetzt werden. Hierbei ist die Anpassung der Greifer an Form und Druckempfindlichkeit der zu bewegenden Gegenstände mit aufwändigen Einstell- und Steuerungsfunktionen verbunden. Zusätzlich ist eine sehr exakte Erfassung (ggf. optisch) der Lage des empfindlichen Gegenstandes erforderlich, um deren Verletzung oder Zerstörung zu vermeiden. Hierzu gehören z. B. Lebensmittel, beispielweise rohe Eier, Schokoladenhohlkörper, Pflanzen, fragile technische Erzeugnisse etc. Aus dem Stand der Technik sind Vorrichtungen bekannt, welche eine komplizierte Mechanik aufweisen, die sich den zu greifenden Gegenständen anpasst und einer ebenso komplexen Steuerung wie einer interaktiven Steuersensorik bedarf. Hinzu kommt die aufwendige Herstellung dieser Mechanik.
Der Erfindung liegt die Aufgabe zugrunde, ein Verfahren und eine Vorrichtung sowie einen Manipulator zum Handhaben von Gegenständen vorzuschlagen, mit welchen die aus dem Stand der Technik bekannten Nachteile vermieden oder zumindest stark verringert werden.

Die Aufgabe wir gelöst mit einer Vorrichtung gemäß Anspruch 1.

Die erfindungsgemäße Vorrichtung zum Handhaben von Gegenständen kann vorteilhafterweise an einen Gegenstand heran bewegt werden, bis die Haltevorrichtung in Kontakt mit dem Gegenstand kommt und diesen fest hält. Hierbei kann die Luftkammer bereits geringfügig aufgeblasen sein und somit eine "harte" Kontaktaufnahme mit dem Gegenstand vermeiden helfen. Nach Entstehen einer Verbindung zwischen der Haltevorrichtung und dem Gegenstand kann die Vorrichtung in irgendeiner gewünschten Weise und in irgendeine gewünschte Position verfahren werden, in welcher der Gegenstand wieder von der Vorrichtung gelöst werden soll. Dies ist nun aufgrund der vorteilhaften Ausbildung der erfindungsgemäßen Vorrichtung ohne Beschädigung des Gegenstandes dadurch möglich, dass die Luftkammer aufgeblasen wird mit der Folge, dass durch die beim Aufblasen entstehende Wölbung der Luftkammer die Haltevorrichtung Stück für Stück sanft von dem Gegenstand ab- oder weggedrückt wird und zwar solange, bis die Halteverbindung zwischen Haltevorrichtung und Gegenstand im Kontaktbereich nicht mehr ausreicht, um den Gegenstand zu halten. Bei diesem Vorgang wird der Umstand ausgenützt, dass sich die äußere Form des Gegenstands nicht der Aufwölbung der aufgeblasenen Luftkammer anpasst.

Erfindungsgemäß weist die Luftkammer der Vorrichtung wenigstens zwei textile Gewebelagen auf. Zwar wäre es möglich, eine Luftkammer aus Kunststofffolie oder anderen weichen Materialien zu verfertigen. Die Ausbildung der Luftkammer mit wenigstens zwei textilen Gewebelagen ist wesentlich flexibler, erlaubt gleichzeitig eine universelle Formgebung wie auch den Vorteil der Bestimmung der gewünschten Festigkeit des Materials und dies auf sehr wirtschaftliche Weise. Eine variable Einstellung der spezifischen Haltekraft der Haltevorrichtung ist einfacher zu bewerkstelligen.

In einer vorteilhaften Ausbildung der Erfindung weist die Luftkammer wenigstens eine um die zwei textilen Gewebelagen verlaufende Naht auf. Die Naht bietet die Möglichkeit, im Bereich unmittelbar in der Nähe der Luftkammer Applikationen, wie z. B. Haltevorrichtungen und dergleichen anzubringen. Selbstverständlich können aber auch direkt im Bereich der Gewebelagen derartige Applikationen angeordnet werden.

In einer weiteren vorteilhaften Ausbildung der Erfindung sind die zwei textilen Gewebelagen im Sinne des Nähvorgangs als solchem tatsächlich entlang der Naht je nach gewünschter Festigkeit oder Sicherheitsanforderung mit einem oder mehreren Fäden vernäht. Alternativ könnte auch eine Klebung oder Verschweißung und dergl. eingesetzt werden. (A4)

In noch einer weiteren vorteilhaften und besonders bevorzugten Ausbildung der Erfindung sind die zwei textilen Gewebelagen in einem Stück miteinander als OPW-Gewebe (One-Piece-Woven-Gewebe) verwebt, wobei die Naht einen die zwei textilen Gewebelagen (zweilagiger Bereich) umgebenden einlagigen Bereich als Webnaht darstellt und die Luftkammer umgibt. Mit dieser erfindungsgemäßen Ausbildung der Vorrichtung stehen alle Vorteile der OPW-Technologie zur Verfügung, von denen nur einige genannt werden sollen. Der Einsatz der OPW-Technologie erlaubt die Fertigstellung der Luftkammer gleichsam vollautomatisch in einem einzigen Arbeitsschritt. Das Weben der Luftkammer, das Konfigurieren und die Konfektionierung geschehen mit höchster Präzision und dies gleichzeitig. Sämtliche bei anderen Technologien erforderlichen zusätzlichen Arbeitsschritte wie zueinander Positionieren von Teilen der Luftkammer zum Nähen, Positionieren der Nähnaht und das Nähen selbst etc. entfallen. Auch die bei der konfektionstechnischen Lösung erforderliche gesonderte Abdichtung von "Nähnähten" entfällt.

In einer weiteren vorteilhaften Ausbildung der Erfindung ist die Haltevorrichtung als Klebemittel enthaltende Haftbeschichtung ausgebildet. Diese kann für sehr leichtgewichtige Gegenstände z. B. unterfixiertes Silikon sein.

In einer weiteren vorteilhaften Ausbildung der Erfindung weist die Haltevorrichtung Magnete auf. Diese Ausgestaltung hat sich für die Handhabung von eisenmetallischen Gegenständen als sehr vorteilhaft erwiesen.

In einer weiteren vorteilhaften Ausbildung der Erfindung weist die Haltevorrichtung wenigstens eine Wirkungsfläche einer Klettverbindung auf.

In einer weiteren vorteilhaften Ausbildung der Erfindung ist die Vorrichtung dadurch gekennzeichnet, dass sie mehrere voneinander beabstandete Luftkammern und mehrere zwischen den Luftkammern angeordnete Haltevorrichtungen aufweist. Damit erhöhen sich die Funktionssicherheit und die Zahl der Einsatzmöglichkeiten der Vorrichtung wesentlich.

Die Aufgabe wir auch gelöst mit einem Roboter oder Manipulator gemäß Anspruch 9, der gekennzeichnet ist durch wenigstens eine Vorrichtung zum Handhaben von Gegenständen.

Die Aufgabe wird des Weiteren gelöst mit einem Verfahren zum Handhaben von Gegenständen gemäß Anspruch 10, welches gekennzeichnet ist durch folgende Schritte:
e) Bewegen der erfindungsgemäßen Vorrichtung mit ihrer die Haltevorrichtung aufweisenden Seite zu dem zu handhabenden Gegenstand in eine erste Position,
f) Zulassen einer Haftverbindung zwischen der Haltevorrichtung und dem zu handhabenden Gegenstand und damit Festhalten des Gegenstandes,
g) Verfahren der Vorrichtung in eine gewünschte zweite Position,
h) Lösen des Gegenstandes von der Haltevorrichtung durch Aufblasen der wenigstens einen Luftkammer.

Die Vorteile dieses erfindungsgemäßen Verfahrens liegen auf der Hand. Sie sind oben bei der Beschreibung der Vorteile der erfindungsgemäßen Vorrichtung und Ihres Einsatzes bereits ausführlich dargestellt worden.

Es ist vorteilhafterweise in erster Linie das Ziel, OPW-Bauteile in Bereiche wie Automatisierung, Logistik, Verpackung und dergl. einzuführen und dabei komplexe Lösungen durch einfachere zu substituieren. Die Funktionen: Aufgreifen und Ablegen werden durch Druckbeaufschlagung, bzw. Evakuierung gesteuert. Das Manipulieren übernimmt wie bisher ein Roboter- oder Manipulatorarm. Konstruktionselemente zur Herstellung von OPW-Bauteilen sind z. B.:
Integrierte Elemente (Designs):
   - X-Tether
   - Tube-Tether
   - Tubes
Kombinationsbauteile OPW und Konfektion:
   - Kombination von Tubes und Flachgewebe
   - Kombination von Tubes unterschiedlichen Durchmessers
Weitere:
   - Pneumatik-Verbindungen
   - Beschichtung (Veredlung)

Zum besseren Verständnis der Erfindung wird diese im Folgenden anhand von Ausführungsbeispielen unter Zuhilfenahme einer Zeichnung kurz beschrieben.
- Fig. 1a: zeigt stark schematisiert ein erstes Ausführungsbeispiel der erfindungsgemäßen Vorrichtung in der Draufsicht.
- Fig. 1b: zeigt die Vorrichtung nach Fig. 1 a im Schnitt bei nicht aufgeblasener Luftkammer.
- Fig. 1c: zeigt die Vorrichtung nach Fig. 1 a im Schnitt bei aufgeblasener Luftkammer und abgesenktem Gegenstand.
- Fig. 2a: zeigt ein zweites Ausführungsbeispiel der erfindungsgemäßen Vorrichtung mit Klettbändern oder Magneten.
- Fig. 2b: zeigt die Vorrichtung nach Fig. 2a im Schnitt bei nicht aufgeblasener Luftkammer.
- Fig. 2c: zeigt die Vorrichtung nach Fig. 2a im Schnitt bei aufgeblasener Luftkammer und abgesenktem Gegenstand.
- Fig. 3: zeigt schematisch einen Ausschnitt aus einer OPW-Gewebebahn, in welcher noch nicht ausgeschnittene individuell designte Bauteile zu erkennen sind.
- Fig. 4 bis 7: zeigen schematisch ein Ausführungsbeispiel II, "Übergabegreifer" in verschiedenen Positionen der Vorrichtung.

In der folgenden Beschreibung sind gleiche oder analoge Bauteile mit gleichen Bezugzeichen versehen.

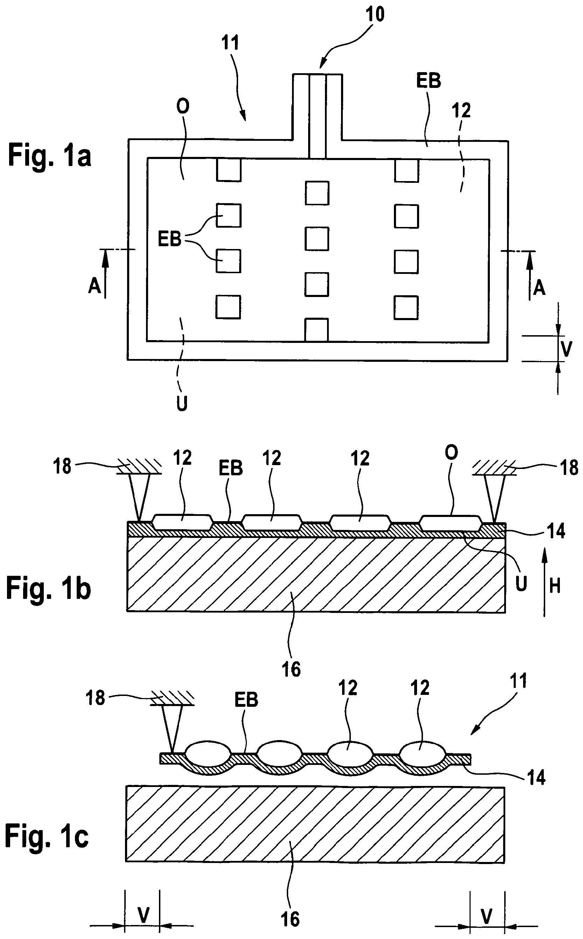

Fig. 1 a zeigt eine erfindungsgemäße Vorrichtung 11 mit einer - da zwischen Gewebelagen O und U liegenden und deshalb nicht sichtbaren - mit einer vorzugsweise als OPW ausgebildeten Luftkammer 12. Einlagige Bereiche im Innenbereich der Vorrichtung 11 und die Umgebungsnaht sind mit EB bezeichnet. Die Luftkammer kann auch aus zwei konventionell zusammengenähten Gewebelagen O, U bestehen. Bei diesem Ausführungsbeispiel ist vollflächig, jedoch nicht unbedingt erforderlich vollflächig, an der Luftkammer 12 eine Haltevorrichtung 14 für Gegenstände 16 in Form einer Klebebeschichtung befestigt (Fig. 1 b). An Punkten 18 und weiteren Punkten kann die Vorrichtung 11 an einem (nicht gezeigten) Manipulator oder Roboter angebracht werden. Oben in Fig. 1a ist ein Einblasmund 10 für die Luftkammer 12 vorgesehen.

Fig. 1b zeigt eine Schnittansicht A-A der Vorrichtung 11 entlang der Linie A-A nach Fig. 1 a. In dieser Position kommt die Vorrichtung 11 in Kontakt mit dem Gegenstand 14. An der an der Luftkammer 12 befestigten Haltevorrichtung 14, hier als Klebeschicht ausgebildet, haftet der Gegenstand 16 an und kann in Richtung des Pfeils H angehoben und dann irgendwie nach Wunsch verfahren werden. Fig. 1c zeigt die Vorrichtung 11 nach dem Aufblasen der Luftkammer 12. Gut zu erkennen ist, dass sich die Länge der Vorrichtung 11 infolge des Aufblasens der Luftkammern 12 zweimal um die Strecke V gegenüber der ursprünglichen Länge verkürzt hat. Hierbei haben sich die Luftkammern 12 und mit ihnen die Halte-/Haftvorrichtung 12 gewölbt und durch Verringern der Kontaktfläche mit dem Gegenstand 16 die Halte- bzw. Haftkraft derart verringert, dass der Gegenstand 16 nicht mehr gehalten wird und sich von der Vorrichtung 11 löst. In der Darstellung nach Fig. 1c hat die erfindungsgemäße Vorrichtung 11 den Gegenstand 16 eben abgelegt.

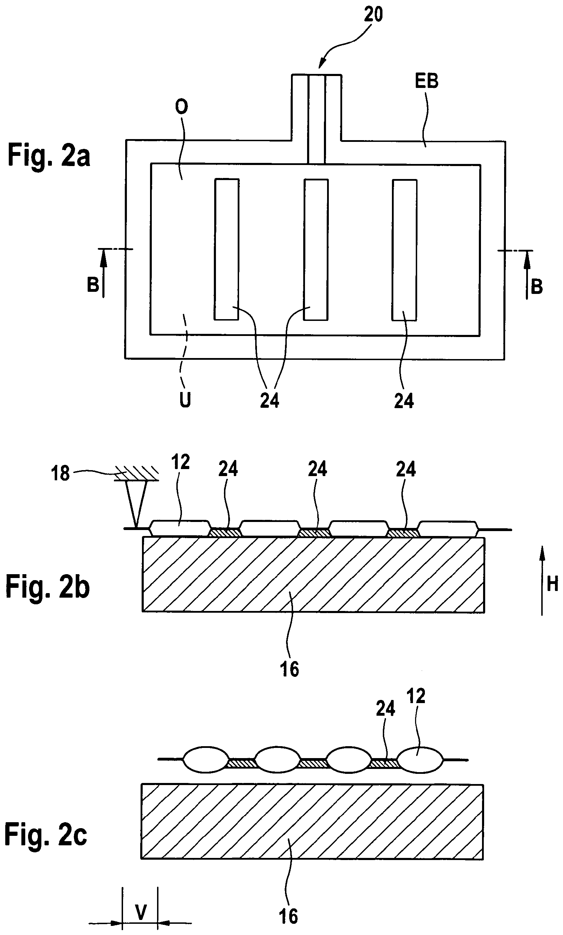

Eine in den Fig. 2a bis 2c gezeigte alternative Ausführungsform der Erfindung ersetzt die Haltevorrichtung 14 als Klebeschicht ausgebildet, durch eine Haltevorrichtung 24, hier beispielsweise als Klettverbindungsbänder 24 oder als beispielsweise aufgenähte Magnetbänder 24 ausgebildet. Funktion und Funktionsablauf entsprechen denen des ersten Ausführungsbeipiels.

Bei beiden Varianten wird die Funktion des Ablegens durch Druckbeaufschlagung des OPW-Bauteils 12, (Verkürzung, Flächenreduktion, dritte Dimension insbesondere auch Scherkräfte) gesteuert.

Im Folgenden wird noch auf weitere Vorteile und besondere Merkmale der Erfindung hingewiesen. Die Ausbildung der Luftkammer als OPW-Bauteil ermöglicht eine variable Einstellung der absoluten Haftkraft. Die Designgebung ist durch individuelles Weben auf die Anforderung hin möglich. Die Klebebeschichtung ist für leichte Gegenstände besonders geeignet. Die konfektionstechnische Kombination unterschiedlicher textiler Bauteile wie OPW und Flachgewebe eröffnet grenzenlose Gestaltungsmöglichkeiten. Die Nutzung der bei Druckbeaufschlagung gegebenen mechanischen Bewegungen (Dicke, Verkürzung, Reduzierung der Auflagefläche, Drehbewegung, Zugbewegung, Scherkräfte/-bewegung) können genutzt werden. Einstellbar und individuell wählbar sind die Übergabe durch variable Einstellung der Haftkraft zweier gleichsam als Greifer ausgebildete erfindungsgemäße Vorrichtungen, die Relation der Haftkraft zw. Haftflächen und die Reduktion Haftkraft zu Gewichtskraft

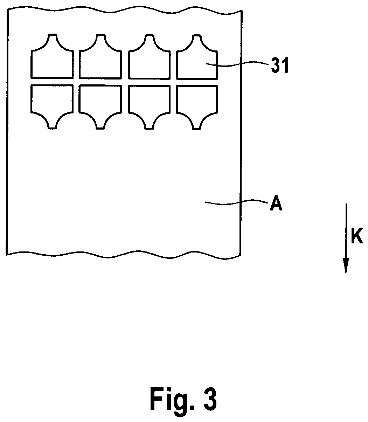

In Fig. 3 wird ein Ausschnitt A aus einer OPW-Gewebebahn, in welchem noch nicht ausgeschnittene individuell designte abgepasst gewebte Bauteile mit integrierten Konstruktionsmerkmalen, X-Tethern, Tubes, Zugfäden und dergl. oder z. B mit Luftkammern 32 versehene erfindungsgemäße Vorrichtungen 31 zu erkennen sind. Der Pfeil K zeigt die Richtung des Kettfadenverlaufs an.

### Weitere Merkmale der Erfindung:

### Erfindung Haftgreifer/Hebegreifer

Das Ziel der Erfindung ist es, einen Greifer mit variabel einstellbarer absoluter Haftkraft bereitzustellen. Auf einer Fläche wird eine Haftmöglichkeit (z.B. unterfixiertes Silikon, Klettband, Magnete) teilweise oder vollflächig aufgebracht.

Das spezifische Haftvermögen dieser Haftmöglichkeit wird anforderungsbezogen ausgestaltet und eingestellt. Die Gesamthaftkraft ergibt sich aus dem Produkt der Fläche und der spezifischen Haftkraft.

Durch mechanische Verformung wird die absolute Haftkraft verändert, in dem die Haftfläche reduziert wird, d.h. Reduzierung der Menge der Haftpunkte

### Beispiel I, Hebegreifer:

- Gegeben: Gewichtskraft des zu bewegenden Gutes:: 80 bis 100 N
- Gegeben: Spezifisches Haftvermögen der Haftfläche: 0,5 N/cm²
- a) Parameter des Greifers, Haftvermögen zu heben: > 100N (kommend vom max. Gewicht des Gutes)
- => Greiferfläche: > 200 cm²
- b) Parameter des Greifers, Haftvermögen lösen: < 80N (kommend vom min. Gewicht des Gutes)
- => Greiferfläche: < 160 cm²

Zur Umsetzung wird im Vorhergehenden beschrieben und hier noch einmal in Form eines OPW-Greifers beschrieben. Dieses beschreibt ein OPW-Bauteil, welches mit einer Haftmöglichkeit versehen ist. In Figur 1 a sei eine Haftfläche (hier > 200cm²) angenommen, die mit einer Haftfähigkeit / Haftmöglichkeit versehen ist. In Figur 1 b kommt die gesamte Haftfläche mit dem Gegenstand 16 (Gut) in Verbindung. Die Reduzierung der Haftfläche in Figur 1c) erfolgt durch eine Druckbeaufschlagung. Das Gut ist nur noch tangential mit der der Haftmöglichkeit verbunden. Dadurch reduziert sich die Haftfläche (hier < 160cm²). Das Gut löst sich durch das Eigengewicht vom Greifer (Gewichtskraft > absolute Haftkraft).

### Beispiel II, Übergabegreifer

### Gegebene Werte: wie bei Beispiel I angegeben

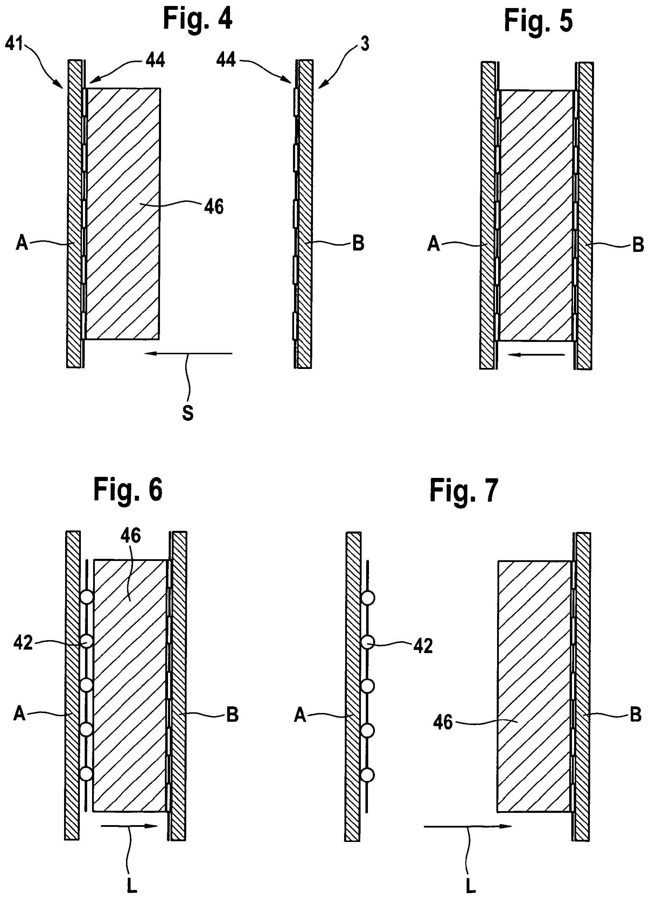

Der Übergabegreifer A, B nach Fig. 4 bis 7 verwendet eine erfindungsgemäße Vorrichtung 41 mit Luftkammern 42 und daran angeordneter als Haftvorrichtung (analog zum Ausführungsbeispiel nach Fig. 1a bis 1c) ausgebildeter Haltevorrichtung 44. Der Gegenstand 46 oder das Gut 46 haftet zunächst am Greifer A (Fig. 4 links). Die Haftfläche 44 ist zunächst nicht druckbeaufschlagt.

Der Greifer B fährt gemäß Pfeil S in Richtung Greifer A, das Gut 46 kommt mit der Haftfläche 44 in Berührung / Verbindung. Die Reduzierung der absoluten Haftfläche erfolgt durch eine Druckbeaufschlagung der Haftfläche 44. Das Gut 46 ist nur noch tangential mit der der Haftmöglichkeit auf der Haftfläche 44 verbunden. Dadurch reduziert sich die Haftfläche 44 des Greifers B und damit die absolute Haftkraft, so dass die absolute Haftkraft Greifer B größer ist, als die des Greifers A. In diesem Fall kann die absolute Haftkraft auch größer als das Gewicht des Gutes 46 sein.

Fig. 6 zeigt: Beim Auseinanderfahren der Greifer A und B - Greifer B bewegt sich in Richtung des Pfeils L - verbleibt das Gut 46 an Greifer B, da hier die absolute Haftkraft höher ist und löst sich von Greifer A. Der Vorgang ist umkehrbar und, bis auf die Ausrichtung entgegen der Gravitation, im Raum lageunabhängig.

Es ist eine Funktionsumkehr je nach Oberflächenbeschaffenheit des Guts denkbar, sodass das Gut bei Druckentlastung sich vom Greifer löst.

## Patentansprüche

1. Vorrichtung zum Handhaben von Gegenständen, mit
a) wenigstens einer aufblasbaren Luftkammer (12),
b) einer an der Luftkammer (12) befestigten Haltevorrichtung (14) für Gegenstände (16),
**dadurch gekennzeichnet, dass** die Luftkammer (12) wenigstens zwei textile Gewebelagen (O, U) aufweist.

2. Vorrichtung nach Anspruch 1, **dadurch gekennzeichnet, dass** die Luftkammer (12) wenigstens eine um die zwei textilen Gewebelagen (O, U) verlaufende Naht (N) aufweist.

3. Vorrichtung nach Anspruch 1 oder 2, **dadurch gekennzeichnet, dass** die zwei textilen Gewebelagen (O, U) entlang der Naht (N) vernäht sind.

4. Vorrichtung nach Anspruch 1 oder 23, **dadurch gekennzeichnet, dass** die zwei textilen Gewebelagen (O, U) in einem Stück miteinander als OPW-Gewebe (One-Piece-Woven-Gewebe) verwebt sind, wobei die Naht (N) einen die zwei textilen Gewebelagen (O, U) umgebenden einlagigen Bereich (EB) als Webnaht (WN) darstellt und die Luftkammer (12) umgibt.

5. Vorrichtung nach Anspruch 4, **dadurch gekennzeichnet, dass** die Haltevorrichtung (14) als Klebemittel enthaltende Haftbeschichtung ausgebildet ist.

6. Vorrichtung nach Anspruch 4, **dadurch gekennzeichnet, dass** die Haltevorrichtung (14) Magnete aufweist.

7. Vorrichtung nach Anspruch 5, **dadurch gekennzeichnet, dass** die Haltevorrichtung (14) wenigstens eine Wirkungsfläche einer Klettverbindung aufweist

8. Vorrichtung nach einem der vorhergehenden Ansprüche, **dadurch gekennzeichnet, dass** sie
c) mehrere voneinander beabstandete Luftkammern (12) und
d) mehrere zwischen den Luftkammern (12) angeordnete Haltevorrichtungen (14) aufweist.

9. Roboter oder Manipulator, **gekennzeichnet durch** wenigstens eine Vorrichtung zum Handhaben von Gegenständen nach einem der vorhergehenden Ansprüche.

10. Verfahren zum Handhaben von Gegenständen mit einer Vorrichtung nach einem der Ansprüche 1 bis 8, das folgende Schritte aufweist:
e) Bewegen der Vorrichtung mit ihrer die Haltevorrichtung (14) aufweisenden Seite zu dem zu handhabenden Gegenstand (16) in eine erste Position (I),
f) Zulassen einer Haftverbindung zwischen der Haltevorrichtung (14) und dem zu handhabenden Gegenstand (16) und damit Festhalten des Gegenstandes (16),
g) Verfahren der Vorrichtung in eine gewünschte zweite Position (II),
h) Lösen des Gegenstandes (16) von der Haltevorrichtung durch Aufblasen der wenigstens einen Luftkammer.

## Claims

1. A device for handling objects comprising
a) at least one inflatable air chamber (12)
b) a device for gripping (14) objects (16) secured to said air chamber (12,
**characterized in that**
said air chamber (12) comprises at least two textile fabric layers (O, U).

2. The device as set forth in claim 1, **characterized in that** said air chamber (12) comprises at least one seam (N) surrounding the two textile fabric layers (O, U).

3. The device as set forth in claim 1 or 2, **characterized in that** said two textile fabric layers (O, U) are stitched along the seam (N).

4. The device as set forth in claim 1, 2 or 3, **characterized in that** said textile fabric layers (O, U) are interwoven in one piece (one-piece-woven fabric), the seam (N) constitutes a single-layer portion (EB) surrounding the textile fabric layers (O, U) as woven seam (WN) and surrounding the air chamber (12)).

5. The device as set forth in claim 4, **characterized in that** said gripping device (14) is configured as an adhesive layer containing an adhesive.

6. The device as set forth in claim 4 **characterized in that** said gripping device (14) comprises magnets.

7. The device as set forth in claim 5 **characterized in that** said gripping device (14) comprises at least one effective area of a velcro fastener.

8. The device as set forth in any of the preceding claims, **characterized in that** it comprises
c) several air chambers (12) each spaced from the other and
d) several gripping devices (14) arranged between the air chambers (12).

9. A robotic or manipulator device, **characterized by** at least one handling device as set forth in any of the preceding claims.

10. A method for handling objects by a device as set forth in any of the claims 1 to 8 comprising the following steps:
e) moving the device with its side comprising the gripping device (14) to the object (16) being handled in a first position (I),
f) allowing an adhesive connection between the gripping device (14) and the object (16) being handled in thus gripping the object (16),
g) forwarding the device to a wanted second position (II),
h) releasing the object (16) from the gripping device by inflating the at least one air chamber.

## Revendications

1. Dispositif pour manipuler des objets avec
a) au moins une chambre d'air gonflable (12),
b) un dispositif de support (14) pour les objets (16) fixé à la chambre d'air (12),
**caractérisé en ce que**
la chambre d'air (12) comprend au moins deux couches de tissus textiles (O, U).

2. Dispositif selon la revendication 1, **caractérisé en ce que** la chambre d'air (12) présente au moins une couture (N) autour des deux couches de tissus textiles (O, U).

3. Dispositif selon la revendication 1 ou 2, **caractérisé en ce que** les deux couches de tissus textiles (O, U) sont cousues le long de la couture (N).

4. Dispositif selon la revendication 1, 2 ou 3, **caractérisé en ce que** les deux couches de tissus textiles (O, U) sont tissées d'une pièce en OPW (One-Piece-Woven) et que la couture (N) constitue un secteur à une couche (EB) entourant les deux couches de tissus (O, U) comme couture de tissage (WN) et entoure la chambre d'air (12).

5. Dispositif selon la revendication 4, **caractérisé en ce que** le dispositif de support (14) est constitué d'un revêtement adhésif contenant une colle.

6. Dispositif selon la revendication 4, **caractérisé en ce que** le dispositif de support (14) contient des aimants.

7. Dispositif selon la revendication 5, **caractérisé en ce que** le dispositif de support (14) présente au moins une surface effective avec une liaison agrippante.

8. Dispositif selon l'une des revendications précédentes, **caractérisé en ce que**
c) il présente plusieurs chambres d'air (12) distantes les unes des autres et
d) plusieurs dispositifs de supports (14) agencés entre les chambres d'air (12).

9. Un robot ou un manipulateur, **caractérisé par** au moins un dispositif pour manipuler des objets selon l'une des revendications précédentes.

10. Procédé pour manipuler des objets avec un dispositif selon l'une des revendications précédentes 1 à 8 présentant les étapes suivantes :
e) Déplacement du dispositif avec le côté comprenant le dispositif de support (14) orienté vers l'objet à manipuler (16) dans une première position (I),
f) permettant ainsi une liaison adhérente entre le dispositif de support (14) et l'objet à manipuler (16) et, donc, le maintien de l'objet (16) ;
g) déplacement du dispositif dans une deuxième position souhaitée (II) ;
h) détachement de l'objet (16) du dispositif de support en gonflant au moins une chambre d'air.
